# EUROPEAN PATENT APPLICATION

(11) **EP 1 621 563 A1**
(43) Date of publication of application: **01.02.2006**
(21) Application number: 05016331.0
(22) Date of filing: 27.07.2005
(51) Int. Cl.: C08G 18/02, C08G 18/71, C08G 18/76

(54) **Resin for optical-semiconductor element encapsulation**

(30) Priority: 27.07.2004 JP 2004219032
(71) Applicant: NITTO DENKO CORPORATION, Osaka (JP)
(72) Inventor: Uwada, Kazuki, Ibaraki-shi, Osaka (JP); Hotta, Yuji, Ibaraki-shi, Osaka (JP); Sadayori, Naoki, Ibaraki-shi, Osaka (JP)
(74) Representative: Grünecker, Kinkeldey, Stockmair & Schwanhäusser Anwaltssozietät

(57) **Abstract**

The present invention provides a resin for encapsulating an optical-semiconductor element, comprising a polycarbodiimide represented by the following general formula (1): 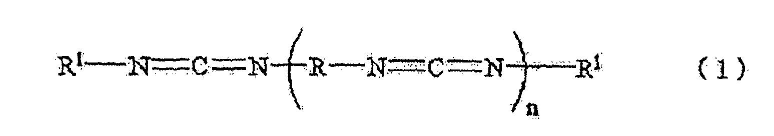 wherein R represents a diisocyanate residue, provided that at least one of the n pieces of the R groups is a diisocyanate residue having the framework represented by the following structural formula (2); 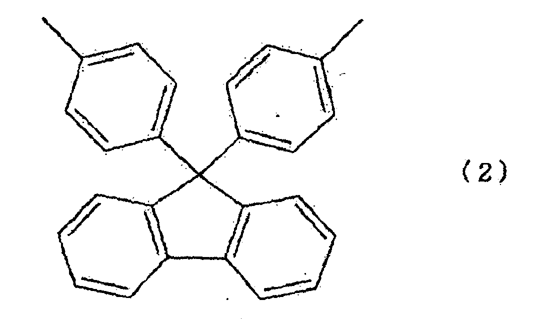 R¹ represents a monoisocyanate residue; and n is an integer of 1 to 100.

## Description

### FIELD OF THE INVENTION

The present invention relates to a resin for encapsulating an optical-semiconductor element, an optical semiconductor device comprising an optical semiconductor element encapsulated with the resin, and a process for producing the device.

### BACKGROUND OF THE INVENTION

Encapsulating materials heretofore in general use for the encapsulation of optical semiconductor elements such as light-emitting elements and light-receiving elements are epoxy resin compositions comprising an epoxy resin (encapsulating resin), such as a bisphenol A epoxy resin or alicyclic epoxy resin, and an acid anhydride hardener, from the standpoint that the encapsulating materials should be excellent in transparency, moisture resistance, and heat resistance. Various optical semiconductor devices produced through the encapsulation of optical semiconductor elements with such epoxy resin compositions are known (see, for example, patent documents 1 and 2).
Patent Document 1: JP 11-168235 A (page 3, Fig. 1)
Patent Document 2: JP 2000-49387 A (page 3, Fig. 1)

Light-emitting elements have a refractive index of generally about 2 to 5, while the epoxy resins for use as encapsulating resins have a refractive index of about 1.5. There are differences in refractive index between the elements and the resins.

Because of this, in existing optical semiconductor devices (light-emitting diodes) having a light-emitting element encapsulated with an epoxy resin, light reflection occurs at the interface between the light-emitting element and the encapsulating resin and, hence, the efficiency of light takeout decreases accordingly, resulting in a reduced luminance. The degree of luminance reduction increases as the difference in refractive index between the light-emitting element and the encapsulating resin increases.

In light-receiving elements also, there are cases where a large difference in refractive index between the light-receiving element and the encapsulating resin results in a decrease in light-receiving sensitivity.

Furthermore, although the encapsulation of an optical semiconductor element with an epoxy resin is generally conducted by potting or transfer molding using a liquid resin, these techniques necessitate molds and a large apparatus. In the case of transfer molding, there is a further problem that it requires an excess resin for parts other than resin encapsulation parts.

### SUMMARY OF THE INVENTION

An object of the invention is to provide a resin for encapsulating an optical-semiconductor element which is, as compared to existing encapsulating resins, capable of keeping the luminance or the light-receiving sensitivity of an optical-semiconductor element in the case where the optical semiconductor element to be encapsutaled is a light-emitting element or a light-receiving element, respectively, at a higher level and which makes the encapsulation of optical semiconductor elements easier, and also which is excellent in economical efficiency.

Another object of the invention is to provide an optical semiconductor device comprising an optical semiconductor element encapsulated with the resin and has excellent performances.

A still other object of the invention is to provide a process for producing the device with high efficiency.

Other objects and effects of the invention will become apparent from the following description.

The above-described objects have been achieved by providing:
(1) A resin for encapsulating an optical-semiconductor element, comprising a polycarbodiimide represented by the following general formula (1): 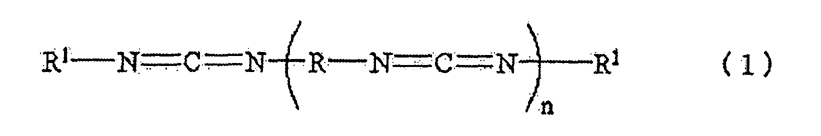
   wherein R represents a diisocyanate residue, provided that at least one of the n pieces of the R groups is a diisocyanate residue having the framework represented by the following structural formula (2); 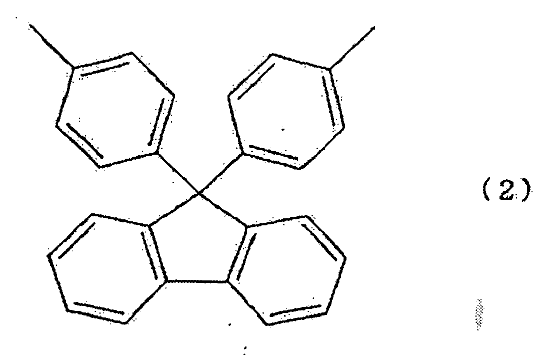 R¹ represents a monoisocyanate residue; and n is an integer of 1 to 100);
(2) The resin for optical-semiconductor element encapsulation as described in item (1) above, wherein at least 10% by mole of the diisocyanate residues are diisocyanate residues having the framework represented by the structural formula (2);
(3) The resin for optical-semiconductor element encapsulation as described in item (1) or (2) above, wherein the monoisocyanate residues comprise aromatic monoisocyanate residues;
(4) The resin for optical-semiconductor element encapsulation as described in item (3) above, wherein the aromatic monoisocyanate residues comprise 1-naphthyl isocyanate residues;
(5) A resin sheet for optical-semiconductor element encapsulation obtained by a process comprising molding the resin for optical-semiconductor element encapsulation as described in any one of items (1) to (4) above into a sheet;
(6) An optical semiconductor device comprising an optical semiconductor element encapsulated with the resin for optical-semiconductor element encapsulation as described in any one of items (1) to (4) above or with the resin sheet for optical-semiconductor element encapsulation as described in item (5) above; and
(7) A process for producing an optical semiconductor device, comprising the steps of:
   placing the resin for optical-semiconductor element encapsulation as described in any one of items (1) to (4) above or the resin sheet for optical-semiconductor element encapsulation as described in item (5) above on an optical semiconductor element; and
   applying heat to the resin or resin sheet.

According to the invention, an encapsulating resin is provided which is, as compared to existing encapsulating resins, capable of keeping, for example, the luminance of a light-emitting element to be encapsutaled at a higher level, and which makes the encapsulation of optical semiconductor elements easier, and also which is excellent in economical efficiency. Consequently, this encapsulating resin can greatly contribute to improvements in performances of optical semiconductor devices and in efficiency of the production thereof.

### BRIEF DESCRIPTION OF THE DRAWINGS

Fig. 1 is a sectional view illustrating one embodiment of the optical semiconductor device of the invention.
Fig. 2 is a sectional view illustrating another embodiment of the optical semiconductor device of the invention.
Fig. 3 is a sectional view illustrating a still other embodiment of the optical semiconductor device of the invention.

The reference numerals used in the drawings denote the followings, respectively.
1: Circuit pattern
2: Substrate
3: Light-emitting element
4: Reflecting layer
5: Bump
6: Underfill resin layer
7: Resin seal
8: Resin seal
9: Substrate
10: Mounting part
11: Lead frame
12: Lead frame
13: Light-emitting element
14: Conductive paste
15: Wire
16: Outer resin layer
17: Inner resin layer

### DETAILED DESCRIPTION OF THE INVENTION

The resin for optical-semiconductor element encapsulation (hereinafter referred to as encapsulating resin) of the invention comprises a polycarbodiimide represented by general formula (1) shown above. The encapsulation of an optical semiconductor element is accomplished by covering the optical semiconductor element with the encapsulating resin and curing the resin. The cured resin obtained by curing the encapsulating resin of the invention has a higher refractive index than the epoxy resins heretofore in wide use as encapsulating resins. Because of this, the encapsulating resin of the invention can attain a reduction in refractive index difference between the optical semiconductor element and the encapsulating resin. Consequently, the encapsulating resin of the invention can keep the luminance or light-receiving sensitivity of the optical semiconductor element to be encapsulated at a higher level, as compared to existing encapsulating resins.

The encapsulating resin of the invention can be used, for example, in a sheet form. Use of this sheet-form encapsulating resin eliminates the necessity of molds or a large apparatus which have been necessary, and makes it easier to encapsulate optical semiconductor elements. Encapsulation can be conducted using the sheet just in the necessary amount to cause no material waste. This encapsulating resin is hence highly excellent in economical efficiency.

The polycarbodiimide for constituting the encapsulating resin of the invention is obtained by subjecting one or more diisocyanates to a condensation reaction and blocking the terminals of the resulting polymer with a monoisocyanate.

In general formula (1), R represents a residue of the diisocyanate used as a starting material, provided that at least one of the n pieces of R groups is a diisocyanate residue having the framework represented by the structural formula (2) shown above, and R¹ represents a residue of the monoisocyanate used as another starting material. Furthermore, n is an integer of 1 to 100.

The polycarbodiimide represented by general formula (1) can be prepared using an aromatic diisocyanate having the framework represented by structural formula (2): 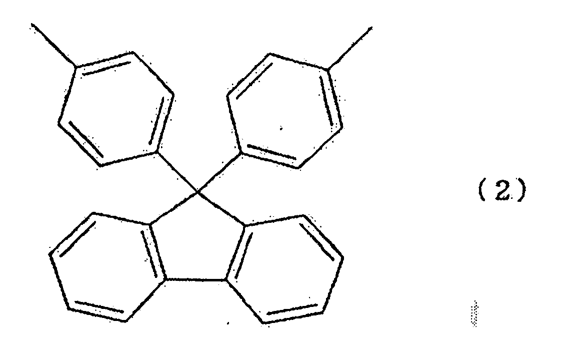 as an essential starting material. Examples of the aromatic diisocyanate include 9,9-bis(4-isocyanatophenyl)fluorene, which is represented by structural formula (3), 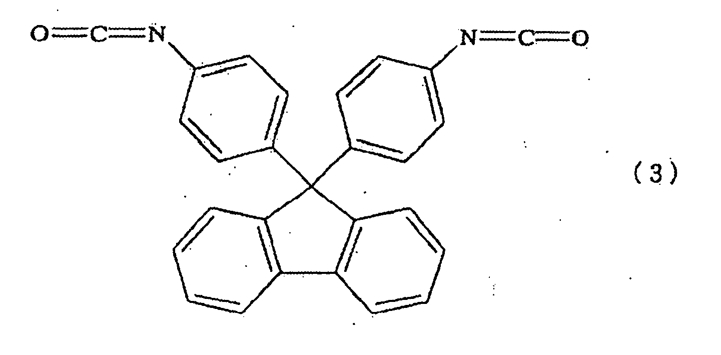 9,9-bis(4-isocyanatophenyl)-3,6-dibromofluorene, 9,9-bis(3-methyl-4-isocyanatophenyl)-3,6-dibromofluorene, and 9,9-bis(3-phenyl-4-isocyanatophenyl)fluorene.

The proportion of the aromatic diisocyanate having the framework represented by structural formula (2) in the total diisocyanate(s) used as starting materials is preferably 10% by mole or higher, more preferably 25% by mole or higher, most preferably 100% by mole.

Besides the aromatic diisocyanate having the framework represented by structural formula (2), an aliphatic diisocyanate and/or an aromatic diisocyanate other than the aromatic diisocyanate having the framework represented by structural formula (2) may be used as a starting-material diisocyanate. From the standpoint of enabling the encapsulating resin to give a cured resin having a higher refractive index, it is preferred to use an aromatic diisocyanate.

Examples of the aliphatic diisocyanate for use in the invention include hexamethylene diisocyanate, dodecamethylene diisocyanate, 2,2,4-trimethylhexamethylene diisocyanate, 4,4'-dicyclohexylmethane diisocyanate, isophorone diisocyanate, cyclohexyl diisocyanate, lysine diisocyanate, and methylcyclohexane 2,4'-diisocyanate.

Examples of the aromatic diisocyanate for use in the invention include m-phenylene diisocyanate, 6-methoxy-2,4-phenylene diisocyanate, 5-bromo-2,4-tolylene diisocyanate, 3,3'-dichloro-4,4'-diphenylmethane diisocyanate, 3,3'-diphenyl-4,4'-diphenylmethane diisocyanate, 3,3',5,5'-tetraethyl-4,4'-diphenylmethane diisocyanate, 4,4'-diphenylisopropylidene diisocyanate, 4,4'-diphenyl ether diisocyanate, 4,4'-diphenyl sulfide diisocyanate, 4,4'-diphenyl sulfoxide diisocyanate, 3,3',5,5'-tetramethyl-4,4'-biphenyl diisocyanate, 3,3'-dimethoxy-4,4'-biphenyl diisocyanate, 3,3'-dibromo-4,4'-biphenyl diisocyanate, bis(4-(4-isocyanatophenoxy)phenyl)methane, 2,2-bis(4-(4-isocyanatophenoxy)phenyl)propane, bis(4-(4-isocyanatophenoxy)phenyl) ether, bis(4-(4-isocyanatophenoxy)phenyl) sulfide, bis(4-(4-isocyanatophenoxy)phenyl) sulfone, 4,4'-diphenylmethane diisocyanate, 2,6-tolylene diisocyanate, and 2,4-tolylene diisocyanate.

Those diisocyanates can be used singly or as a mixture of two or more thereof.

The monoisocyanate to be used as a starting material may be either an aromatic monoisocyanate or an aliphatic monoisocyanate. Either one of an aromatic monoisocyanate(s) or an aliphatic monoisocyanate(s) may be used. Alternatively, a combination of an aromatic monoisocyanate(s) and an aliphatic monoisocyanate(s) may be used. From the standpoint of further increasing the refractive index of the cured resin obtained from the encapsulating resin, it is preferred to use an aromatic monoisocyanate.

Examples of the monoisocyanate for use in the invention include cyclohexyl isocyanate, phenyl isocyanate, p-nitrophenyl isocyanate, p- and m-tolyl isocyanates, p-formylphenyl isocyanate, p-isopropylphenyl isocyanate, and 1-naphthyl isocyanate.

Preferred monoisocyanates are aromatic monoisocyanates because aromatic monoisocyanates do not react with each other and the terminal blocking of a polycarbodiimide with such monoisocyanates proceeds efficiently. It is more preferred to use 1-naphthyl isocyanate.

Those monoisocyanates can be used singly or as a mixture of two or more thereof.

The amount of the monoisocyanate to be used for terminal blocking is preferably in the range of 1 to 10 mol per 100 mol of the diisocyanate ingredient(s) to be used. When a monoisocyanate ingredient is used in an amount of 1 mol or larger per 100 mol of the diisocyanate ingredient, the polycarbodiimide obtained neither has too high a molecular weight nor undergoes a crosslinking reaction. Because of this, the polycarbodiimide solution, for example, undergoes neither an increase in viscosity nor solidification nor a decrease in storage stability. Such monoisocyanate ingredient amounts are hence preferred. On the other hand, when a monoisocyanate ingredient is used in an amount of 10 mol or smaller per 100 mol of the diisocyanate ingredient, the resultant polycarbodiimide solution has an appropriate viscosity. Because of this, film formation from this solution, for example, through application and drying can be satisfactorily conducted. Such monoisocyanate ingredient amounts are hence preferred. The polycarbodiimide solution obtained through terminal blocking with a monoisocyanate used in an amount within that range, in terms of the amount thereof relative to the diisocyanate ingredient amount, is excellent especially in storage stability.

The polycarbodiimide for use in the invention can be produced by subjecting one or more diisocyanates as a starting material to a condensation reaction in a given solvent in the presence of a catalyst for carbodiimide formation, thereby carbodiimidizing, and blocking the terminals of the resultant carbodiimide polymer with a monoisocyanate.

The diisocyanate condensation reaction is conducted at a temperature of generally 0 to 150°C, preferably 10 to 120°C.

The diisocyanate concentration in the reaction mixture is preferably 5 to 80% by weight. As long as the diisocyanate concentration is within this range, carbodiimide formation proceeds sufficiently and reaction control is easy. The diisocyanate concentration range is therefore preferred.

Terminal blocking with a monoisocyanate can be accomplished by adding the monoisocyanate to the reaction mixture in an initial, middle, or final stage of carbodiimide formation from the diisocyanate(s) or throughout the carbodiimide formation. This monoisocyanate preferably is an aromatic monoisocyanate.

As the catalyst for carbodiimide formation can be advantageously used any of known phosphorus compound catalysts. Examples thereof include phospholene oxides such as 1-phenyl-2-phospholene 1-oxide, 3-methyl-2-phospholene 1-oxide, 1-ethyl-2-phospholene 1-oxide, 3-methyl-1-phenyl-2-phospholene 1-oxide, and the 3-phospholene isomers of these.

The solvent (organic solvent) to be used for producing the polycarbodiimide is a known one. Examples thereof include halogenated hydrocarbons such as tetrachloroethylene, 1,2-dichloroethane, and chloroform, ketone solvents such as acetone, methyl ethyl ketone, methyl isobutyl ketone, and cyclohexanone, cyclic ether solvents such as tetrahydrofuran and dioxane, and aromatic hydrocarbon solvents such as toluene and xylene. These solvents can be used singly or as a mixture of two or more thereof. These solvents may be used also for dissolving the polycarbodiimide obtained.

The end point of the reaction can be ascertained by infrared spectroscopy (IR analysis) from the occurrence of absorption attributable to the carbodiimide structure (N=C=N) (2,140 cm⁻¹) and the disappearance of absorption attributable to the isocyanates (2,280 cm⁻¹).

After completion of the carbodiimide-forming reaction, a polycarbodiimide is obtained usually in the form of a solution. However, the solution obtained may be poured into a poor solvent such as methanol, ethanol, isopropyl alcohol or hexane to precipitate the polycarbodiimide and remove the unreacted monomers and the catalyst.

In preparing a solution of the polycarbodiimide which has been recovered as a precipitate, the precipitate is washed and dried in a given manner and then dissolved again in an organic solvent. By performing this operation, the polycarbodiimide solution can have improved storage stability.

In the case where the polycarbodiimide solution contains by-products, the solution may be purified, for example, by adsorptively removing the by-products with an appropriate adsorbent. Examples of the adsorbent include alumina gel, silica gel, activated carbon, zeolites, activated magnesium oxide, activated bauxite, Fuller's earth, activated clay, and molecular sieve carbon. These adsorbents can be used singly or in combination of two or more thereof.

By the method described above, the polycarbodiimide to be used in the invention is obtained. This polycarbodiimide preferably is one in which the backbone structure is constituted of aromatic and aliphatic diisocyanates and the terminals have been blocked with an aromatic monoisocyanate, from the standpoint of further increasing the refractive index of the cured resin obtained from the encapsulating resin. More preferred is one in which the backbone structure is constituted of one or more aromatic diisocyanates and the terminals have been blocked with an aromatic monoisocyanate.

Specifically, the polycarbodiimide is preferably one in which 10% by mole or more of the diisocyanate residues represented by R in general formula (1) are diisocyanate residues having the framework represented by structural formula (2). Further, the polycarbodiimide is preferably one in which the monoisocyanate residues represented by R¹ in general formula (1) comprise aromatic monoisocyanate residues. The aromatic monoisocyanate residues preferably comprise 1-naphthyl isocyanate residues.

The proportion of diisocyanate residues having the framework represented by structural formula (2) in the diisocyanate residues represented by R in general formula (1) can be calculated from the ratio between the diisocyanates used for preparation. Alternatively, the proportion thereof may be determined in the following manner:
- The polycarbodiimide solution obtained is held under the conditions of 80°C and 1 hour at a reduced pressure of 10 mmHg to remove the solvent, and the residual solid is hydrolyzed with an aqueous potassium hydroxide solution by the method described in J. *Appl. Polym. Sci.,* 14, 35(1970) and then extracted with ether;
- The ether phase is examined with a gas chromatograph-mass spectrometer (GC-MS) to determine the amount of the amine which is a hydrolyzate derived from the aromatic or aliphatic diisocyanate used as a starting material;
- Calibration curves obtained with respective standard samples are used for the determination.

The encapsulation of an optical semiconductor element is accomplished by covering the optical semiconductor element with the encapsulating resin of the invention and curing the resin. The refractive index of the cured resin thus obtained from the encapsulating resin is preferably 1.70 or higher, more preferably 1.70 to 1.85. The refractive index thereof can be measured by the method described in Example 1 which will be given later. The refractive index of the cured resin can be regulated to a desired value by suitably selecting the kinds and amounts of the components of the polycarbodiimide constituting the encapsulating resin, etc.

The gel time of the encapsulating resin of the invention is not particularly limited. However, the gel time thereof as measured at 150°C is preferably 0.1 to 5 minutes, more preferably 0.1 to 1 minute. Furthermore, the coefficient of linear expansion of the cured resin obtained by thermally curing the encapsulating resin at 100 to 225°C for 3 to 300 minutes is not particularly limited. However, the coefficient of linear expansion thereof is preferably 7 to 100 (x 10⁻⁶/°C), more preferably 12 to 60 (x 10⁻⁶/°C). When the encapsulating resin has a gel time regulated to a value within that range, it has improved moldability. In particular, a reduction in curing time is possible. When the cured resin has a coefficient of linear expansion regulated to a value within that range, the cured resin and the optical semiconductor element can be prevented from developing stress-induced defects such as cracks. The gel time is measured on a hot plate by a known method. The coefficient of linear expansion is determined by thermomechanical analysis (TMA).

The encapsulating resin of the invention can be formed into a sheet, for example, by the following method. A solution of the polycarbodiimide is formed into a film having an appropriate thickness by a known technique such as, e.g., casting, spin coating, or roll coating. The resultant film (sheet) is usually dried at a temperature necessary for solvent removal. Namely, the film is dried at a temperature regulated to preferably 20 to 350°C, more preferably 50 to 200°C, so as to dry the film without causing a curing reaction to proceed. Drying temperatures not lower than 20°C are preferred because the sheet obtained through drying at such a temperature contains no residual solvent and has high reliability. On the other hand, drying temperatures not higher than 350°C are preferred because the sheet can be sufficiently dried while being inhibited from thermally curing. The drying period is preferably 0.5 to 10 minutes, more preferably 0.5 to 3 minutes. The thickness of the encapsulating resin sheet of the invention is preferably 25 to 500 µm, more preferably 50 to 300 µm, from the standpoint of convenience of use.

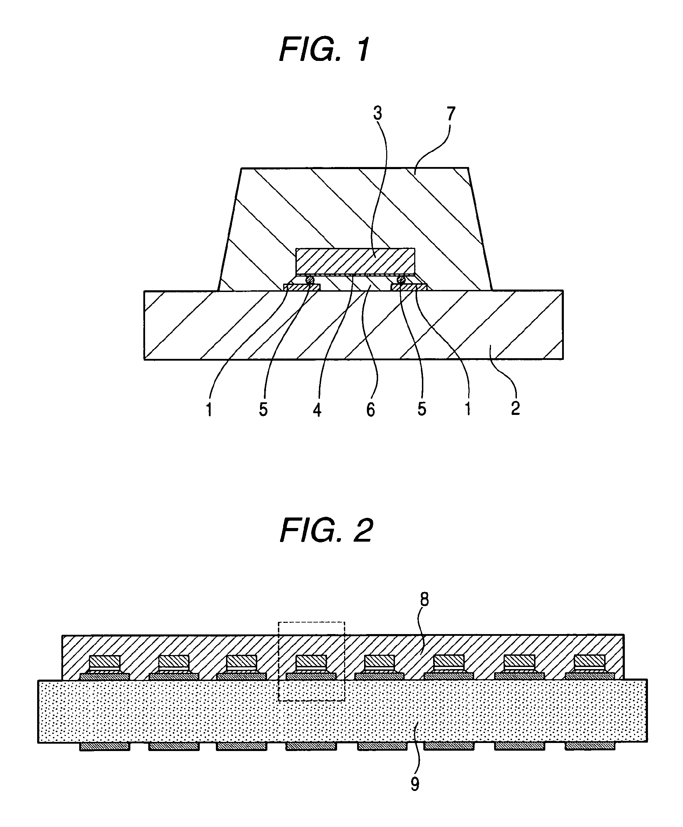

Examples of the optical semiconductor device of the invention, which comprises an optical semiconductor element encapsulated with the encapsulating resin described above, include optical semiconductor devices (light-emitting diodes) such as those shown in Figs. 1 to 3. The optical semiconductor device of the invention and the process of the invention for producing the device will be explained below by reference to these optical semiconductor devices as examples.

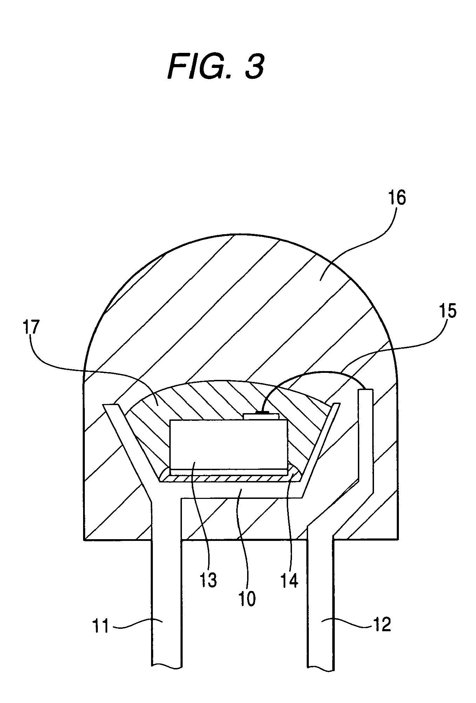

The optical semiconductor devices shown in Figs. 1 and 2 are device examples in which use of the encapsulating resin sheet is suitable for light-emitting element encapsulation. On the other hand, the optical semiconductor device shown in Fig. 3 is a device example in which use of a solution of the encapsulating resin is suitable.

The optical semiconductor device shown in Fig. 1 comprises a substrate 2 having a given circuit pattern 1 and a light-emitting element 3 disposed on the substrate 2. A reflecting layer 4 comprising a layer of a metal, e.g., gold, has been formed over the whole lower side of the light-emitting element 3. The light-emitting element 3 has been electrically connected to the circuit pattern 1 of the substrate 2 through gold or solder bumps 5 by flip chip bonding. The device further has an insulating underfill resin layer 6 which tightly fills the space between the electrodes of the light-emitting element 3. As the underfill resin, for example, an epoxy resin or the encapsulating resin of the invention is used. Furthermore, the light-emitting element 3 has been wholly encapsulated in and protected with a resin seal 7. This resin seal 7 corresponds to a cured resin formed from the encapsulating resin sheet of the invention.

On the other hand, the optical semiconductor device shown in Fig. 2 is a so-called light-emitting diode array, which includes light-emitting elements encapsulated in a resin seal 8, the encapsulated light-emitting elements being arranged on a substrate 9 as constituent units and each comprising the optical semiconductor device shown in Fig. 1. In this figure, the resin seal 8 corresponds to a cured resin formed from the encapsulating resin sheet of the invention. In Fig. 2, a constituent unit comprising the optical semiconductor device shown in Fig. 1 is indicated by broken lines.

The optical semiconductor devices shown in Figs. 1 and 2 can be produced, for example, according to the processes for optical-semiconductor device production described in JP 11-168235 A. In these processes for optical-semiconductor device production described in the document, one or more light-emitting elements are encapsulated with resin seals 7 and 8 formed from an encapsulating resin heretofore in use, such as an epoxy resin. In the present invention, however, optical elements are encapsulated with the encapsulating resin of the invention.

The encapsulation of one or more light-emitting elements disposed on a substrate with the encapsulating resin sheet of the invention can be conducted, for example, by placing on the elements the encapsulating resin sheet having a size which suffices to cover the elements and is appropriate for the shape of the elements, and then heating and press-bonding the resin sheet. The heating/press-bonding can be conducted, for example, under such conditions that the resin sheet is heated at a temperature of 180 to 220°C for about 40 seconds with pressing at a pressure of about 0.2 MPa or higher and then further heated at about 120 to 180°C for about 1 hour. Through this heating/press-bonding, the encapsulating resin sheet of the invention cures. As a result, an optical semiconductor device comprising the light-emitting element(s) encapsulated in this cured resin is obtained as a final product.

In the optical semiconductor device thus produced, the resin seal comprising the cured resin formed from the encapsulating resin of the invention has a higher refractive index than the resin seals formed from encapsulating resins heretofore in use, such as epoxy resins. Because of this, the difference in refractive index (absolute value) between the resin seal and the light-emitting element is small. Consequently, the luminance of the light-emitting elements is kept high as compared with that in related-art techniques.

The optical semiconductor device shown in Fig. 3 has a pair of conductive members comprising a lead frame 11 having a mounting part (mounting member) 10 at its upper end and a lead frame 12, and further has a light-emitting element 13 disposed on the mounting part 10. The light-emitting element 13 has been bonded to the mounting part 10 with a conductive paste 14 and electrically connected to the lead frame 11 with the paste 14. The light-emitting element 13 has been further connected to the lead frame 12 by bonding with a wire 15. The light-emitting element 13 has been encapsulated in and protected with an outer resin layer 16 made of an epoxy resin; the mounting part 10 excluding its inside is filled with this resin layer 16. This resin layer 16 functions also as a lens. The inside of the mounting part 10 is filled with an inner resin layer 17, in which the light-emitting element 13 has been encapsulated. This inner resin layer 17 corresponds to a cured resin formed from the encapsulating resin of the invention.

The optical semiconductor device shown in Fig. 3 can be produced, for example, according to the process for optical-semiconductor device production described in JP 2000-49387 A. In the process for optical-semiconductor device production described in the document, a light-emitting element 13 is encapsulated with an inner resin layer 17 formed from a resin obtained by reacting, e.g., m-xylylene diisocyanate with 4-mercaptomethyl-3,6-dithia-1,8-octanedithiol. In the present invention, however, the encapsulating resin of the invention is used to encapsulate a light-emitting element 13.

The encapsulation of the light-emitting element with the encapsulating resin of the invention can be accomplished, for example, by dropping a solution of the encapsulating resin onto the light-emitting element 13 mounted on the mounting part 10 (i.e., potting) to thereby place the resin on the element 13 and then heating the resin to cure. The heating can be conducted, for example, under such conditions that the resin is heated at a temperature of 180 to 220°C for about 40 seconds and then further heated at 120 to 180°C for about 1 hour. Subsequently, encapsulation with the outer resin layer 16 is carried out so as to encompass the light-emitting element 13 therein. As a result, the optical semiconductor device as a final product is obtained.

In the optical semiconductor device thus produced, the difference in refractive index (absolute value) between the light-emitting element and the inner resin layer is smaller than in the case where the light-emitting element is encapsulated directly in the outer resin layer made of an epoxy resin. In addition, the difference in refractive index (absolute value) between the inner resin layer and the outer resin layer is also small. Because of these, the total reflectance from the emission of light by the light-emitting element to the exit from the surface of the outer resin layer can be reduced. As a result, the luminance of the light-emitting element is kept high.

Examples of the light-emitting element include GaAlAs (red), AlInGaP (yellow and green), InGaN (yellow, green, blue, and ultraviolet), GaP (green), and SiC (blue).

The optical semiconductor device of the invention is obtained by the methods described above. Consequently, the invention provides, in one aspect thereof, a process for producing an optical semiconductor device, comprising the steps of: placing the encapsulating resin or encapsulating resin sheet of the invention on an optical semiconductor element; and applying heat thereto.

The optical semiconductor device of the invention is excellent, for example, in the luminance of the light-emitting element as compared with optical semiconductor devices heretofore in use. Furthermore, according to the process for optical-semiconductor device production of the invention, the optical semiconductor device of the invention can be produced with high efficiency.

### EXAMPLES

The present invention will be illustrated in greater detail with reference to the following Examples, but the invention should not be construed as being limited thereto.

In the following Examples, all synthesis reactions were conducted in a nitrogen stream. IR analysis was made with FT/IR-230 (manufactured by JEOL Ltd.).

### EXAMPLE 1

A polycarbodiimide was produced in the following manner. Into a 500-mL four-necked flask equipped with a stirrer, dropping funnel, reflux condenser, and thermometer were introduced 85.01 g (339.7 mmol) of 4,4'-diphenylmethane diisocyanate, 22.14 g (55.3 mmol) of 9,9-bis(4-isocyanatophenyl)fluorene, and 188.89 g of cyclohexanone. These ingredients were mixed together.

Thereto were added 4.01 g (23.7 mmol) of 1-naphthyl isocyanate and 0.38 g (1.975 mmol) of 3-methyl-1-phenyl-2-phospholene 2-oxide. The resultant mixture was heated to 100°C and held for 2 hours with stirring.

The progress of reactions was ascertained by IR analysis. Specifically, the decrease in the amount of absorption by N=C=O stretching vibration attributable to the isocyanates (2,280 cm⁻¹) and the increase in the amount of absorption by N=C=N stretching vibration attributable to carbodiimide (2,140 cm⁻¹) were followed. After the end point of the reactions was ascertained by IR analysis, the reaction mixture was cooled to room temperature. Thus, a polycarbodiimide solution, i.e., a solution of an encapsulating resin, was obtained. In this polycarbodiimide, 100% by mole of the diisocyanate residues were aromatic diisocyanate residues, and 14% by mole of the aromatic diisocyanate residues were diisocyanate residues having the framework represented by structural formula (2) given above. This polycarbodiimide was represented by general formula (1) given above wherein n had a distribution from 15 to 77.

Subsequently, the encapsulating-resin solution was applied onto a separator (thickness, 50 µm) (manufactured by Toray Industries, Inc.) comprising a poly(ethylene terephthalate) film treated with a release agent (fluorinated silicone). The solution applied was heated at 130°C for 1 minute and then at 150°C for 1 minute. Thereafter, the separator was removed to obtain an encapsulating resin sheet (sheet thickness, 50 µm).

The encapsulating resin sheet was cut into a size of 1 cm x 2 cm. The resin sheet piece obtained was cured by heating at 200°C for 40 seconds and then at 150°C for 1 hour. The cured resin obtained was examined for refractive index with a multi-wavelength Abbe's refractometer (DR-M4, manufactured by ATAGO Co., Ltd.) at 25°C and a wavelength of 589 nm. The refractive index of the cured resin was found to be 1.72. When the curing conditions were changed into heating at 150°C for 1 hour, then the cured resin thus obtained had the same refractive index.

### EXAMPLE 2

A polycarbodiimide was produced in the following manner. Into a 500-mL four-necked flask equipped with a stirrer, dropping funnel, reflux condenser, and thermometer were introduced 66.23 g (264.65 mmol) of 4,4'-diphenylmethane diisocyanate, 15.82 g (39.5 mmol) of 9,9-bis(4-isocyanatophenyl)fluorene, 15.82 g (90.85 mmol) of tolylene diisocyanate (isomer mixture; T-80, manufactured by Mitsui-Takeda Chemical), and 198.17 g of cyclohexanone. These ingredients were mixed together.

Thereto were added 4.01 g (23.7 mmol) of 1-naphthyl isocyanate and 0.38 g (1.975 mmol) of 3-methyl-1-phenyl-2-phospholene 2-oxide. After the resultant mixture was stirred at 25°C for 3 hours, it was heated to 100°C and held for 2 hours with stirring.

The end point of reactions was ascertained by IR analysis in the same manner as in Example 1. The resultant reaction mixture was cooled to room temperature. Thus, a polycarbodiimide solution, i.e., a solution of an encapsulating resin, was obtained. In this polycarbodiimide, 100% by mole of the diisocyanate residues were aromatic diisocyanate residues, and 10% by mole of the aromatic diisocyanate residues were diisocyanate residues having the framework represented by structural formula (2) given above. This polycarbodiimide was represented by general formula (1) given above wherein n had a distribution from 15 to 77.

Subsequently, the encapsulating-resin solution was used to obtain an encapsulating resin sheet (sheet thickness, 50 µm) in the same manner as in Example 1.

The encapsulating resin sheet was examined for the refractive index of the cured resin obtained therefrom, in the same manner as in Example 1. As a result, the refractive index of the cured resin was found to be 1.72.

### EXAMPLES 3 TO 8

The encapsulating resin sheets obtained in Examples 1 and 2 each were used to encapsulate light-emitting elements to thereby produce light-emitting diodes having the same structure as that shown in Fig. 1 (Examples 3 and 4) and produce light-emitting diode arrays having the same structure as that shown in Fig. 2 (Examples 5 and 6). The light-emitting diode arrays each had ten light-emitting elements.

As the light-emitting elements, blue light-emitting InGaN elements were used. In heating/press-bonding for encapsulation, each resin sheet was heated under the conditions of a pressure of 0.4 MPa, temperature of 200°C, and period of 40 seconds and then further heated under the conditions of a pressure of ordinary pressure, temperature of 150°C, and period of 1 hour.

Separately, the encapsulating-resin solutions obtained in Examples 1 and 2 (the solutions prior to film formation) each were used to encapsulate a light-emitting element by potting (drying at 200°C for 40 seconds and subsequent curing at 150°C for 1 hour). Thereafter, the encapsulated elements were further encapsulated with an epoxy resin (NT-8500, manufactured by Nitto Denko Corp.) (encapsulation at a mold temperature of 150°C and a pressure of 5 MPa for a molding period of 4 minutes and subsequent curing at 150°C for 1 hour) to thereby obtain light-emitting diodes having the same structure as that shown in Fig. 3 (Examples 7 and 8). A cured resin obtained from the epoxy resin was examined for refractive index in the same manner as in Example 1. As a result, the refractive index thereof was found to be 1.55.

As the light-emitting elements, blue light-emitting InGaN elements were used.

### COMPARATIVE EXAMPLES 1 TO 3

An epoxy resin (NT-8500, manufactured by Nitto Denko Corp.) was used as an encapsulating resin to encapsulate light-emitting elements and thereby produce a light-emitting diode and a light-emitting diode array respectively having the same structures as those shown in Figs. 1 and 2. The light-emitting diode array had ten light-emitting elements. In Comparative Example 3, a light-emitting diode of the constitution as shown in Fig. 3 was obtained by encapsulating a light-emitting element with a single epoxy resin (NT-8500, manufactured by Nitto Denko Corp.) in an integrated manner not discriminating between the inner resin layer and the outer resin layer.

In producing the light-emitting diodes and light-emitting diode array having the same structures as those shown in Figs. 1 to 3, the encapsulation with an epoxy resin was conducted by encapsulating each element with the resin at a mold temperature of 150°C and a pressure of 5 MPa for a molding period of 4 minutes and then curing the resin at 150°C for 1 hour. A cured resin obtained by curing the epoxy resin under these conditions was examined for refractive index in the same manner as in Example 1. As a result, the refractive index thereof was found to be 1.55.

### TEST EXAMPLE 1

The light-emitting diodes and light-emitting diode arrays obtained in Examples 3 to 8 and Comparative Examples 1 to 3 were examined for luminance with a luminance meter (BM9, manufactured by Topcon). With respect to each light-emitting diode array, all the light-emitting elements were separately examined for luminance and the average of the found values was taken as the luminance of the array. The results of the measurement are shown in Tables 1 and 2.

**Table 1**

| | | Optical semiconductor device device | Refractive index | | Luminance (cd/m²) |
|---|---|---|---|---|---|
| | | | Light-emitting element | Resin seal | |
| Example | 3 | Light-emitting diode | 2.00 | 1.72 | 7335 |
| | 4 | Light-emitting diode | 2.00 | 1.72 | 7335 |
| | 5 | Light-emitting diode array | 2.00 | 1.72 | 7335 |
| | 6 | Light-emitting diode array | 2.00 | 1.72 | 7335 |
| Comparative Example | 1 | Light-emitting diode | 2.00 | 1.55 | 5780 |
| | 2 | Light-emitting diode array | 2.00 | 1.55 | 5780 |

**Table 2**

| | | optical semiconductor device device | Refractive index | | | Luminance (cd/m²) |
|---|---|---|---|---|---|---|
| | | | Light-emitting element | Inner resin layer | Outer resin layer | |
| Example | 7 | Light-emitting diode | 2.00 | 1.72 | 1.55 | 7460 |
| | 8 | Light-emitting diode | 2.00 | 1.72 | 1.55 | 7460 |
| Comparative Example | 3 | Light-emitting diode | 2.00 | 1.55 | 1.55 | 5890 |

The results given in Tables 1 and 2 show that the light-emitting diodes and light-emitting diode arrays obtained in Examples 3 to 8 each had a luminance higher by about 30% than those of the light-emitting diodes and light-emitting diode arrays obtained in Comparative Examples 1 to 3.

The resin for optical-semiconductor element encapsulation of the invention can be used as an encapsulating material for light-emitting elements, optical semiconductor elements, and the like.

While the present invention has been described in detail and with reference to specific embodiments thereof, it will be apparent to one skilled in the art that various changes and modifications can be made therein without departing from the spirit and scope thereof.

The present application is based on Japanese Patent Application No. 2004-219032 filed July 27, 2004, the contents thereof being herein incorporated by reference.

## Claims

1. A resin for encapsulating an optical-semiconductor element, comprising a polycarbodiimide represented by the following general formula (1): 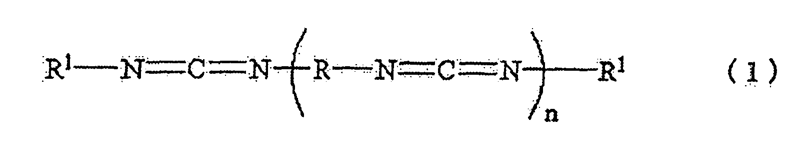
wherein R represents a diisocyanate residue, provided that at least one of the n pieces of the R groups is a diisocyanate residue having the framework represented by the following structural formula (2); 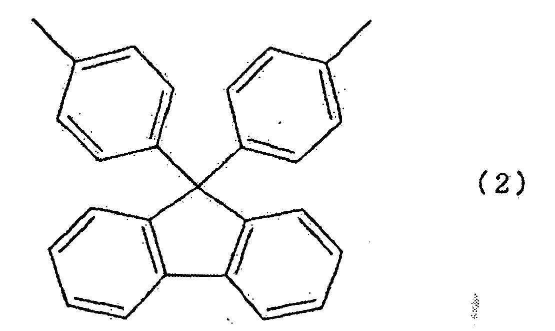 R¹ represents a monoisocyanate residue; and n is an integer of 1 to 100.

2. The resin for optical-semiconductor element encapsulation of claim 1, wherein at least 10% by mole of the diisocyanate residues are diisocyanate residues having the framework represented by the structural formula (2).

3. The resin for optical-semiconductor element encapsulation of claim 1 or 2, wherein the monoisocyanate residues comprise aromatic monoisocyanate residues.

4. The resin for optical-semiconductor element encapsulation of claim 3, wherein the aromatic monoisocyanate residues comprise 1-naphthyl isocyanate residues.

5. A resin sheet for optical-semiconductor element encapsulation obtained by a process comprising molding the resin for optical-semiconductor element encapsulation of any one of claims 1 to 4 into a sheet.

6. An optical semiconductor device comprising an optical semiconductor element encapsulated with the resin for optical-semiconductor element encapsulation of any one of claims 1 to 4 or with the resin sheet for optical-semiconductor element encapsulation of claim 5.

7. A process for producing an optical semiconductor device, comprising the steps of:
placing the resin for optical-semiconductor element encapsulation of any one of claims 1 to 4 or the resin sheet for optical-semiconductor element encapsulation of claim 5 on an optical semiconductor element; and
applying heat to the resin or resin sheet.
